# EUROPÄISCHE PATENTSCHRIFT

(11) **EP 1 120 473 B1**
(45) Veröffentlichungstag und Bekanntmachung des Hinweises auf die Patenterteilung: **28.02.2007**
(21) Anmeldenummer: 01101329.9
(22) Anmeldetag: 22.01.2001
(51) Int. Cl.: C23C 16/34, C23C 30/00, C23C 14/06

(54) **Zerspanungswerkzeug mit Carbonitrid-Beschichtung**
Cutting tool having carbonitride coating
Outil de coupe avec un revêtement de carbonitrure

(30) Priorität: 24.01.2000 DE 10002861
(43) Veröffentlichungstag der Anmeldung: 01.08.2001
(73) Patentinhaber: WALTER AG, 72072 Tübingen (DE)
(72) Erfinder: Schier, Veit, Dr. Ing., 70771 Leinfelden-Echterdingen (DE)
(74) Vertreter: Rüger, Barthelt & Abel Patentanwälte

(56) Entgegenhaltungen:
- WO-A-96/25291
- US-A- 5 840 435
- US-A- 5 846 613
- TAJIMA N ET AL: "WEAR-RESISTANT THIN FILMS OF AMORPHOUS CARBON NITRIDE PREPARED BY SHIELDED ARC ION PLATING" JAPANESE JOURNAL OF APPLIED PHYSICS, PUBLICATION OFFICE JAPANESE JOURNAL OF APPLIED PHYSICS. TOKYO, JP, Bd. 38, Nr. 10A, PART 2, 1. Oktober 1999 (1999-10-01), Seiten L1131-L1133, XP000891129 ISSN: 0021-4922
- VOEVODIN A A ET AL: "Design of a Ti/TiC/DLC functionally gradient coating based on studies of structural transitions in Ti-C thin films" THIN SOLID FILMS, ELSEVIER-SEQUOIA S.A. LAUSANNE, CH, Bd. 298, Nr. 1-2, 20. April 1997 (1997-04-20), Seiten 107-115, XP004085119 ISSN: 0040-6090
- FRANCESCHINI D F ET AL: "Hard amorphous hydrogenated carbon-nitrogen films obtained by PECVD in methane-ammonia atmospheres" DIAMOND AND RELATED MATERIALS, ELSEVIER SCIENCE PUBLISHERS, AMSTERDAM, NL, Bd. 5, Nr. 3-5, 1. April 1996 (1996-04-01), Seiten 471-474, XP004080677 ISSN: 0925-9635

## Beschreibung

Die Erfindung betrifft ein Schneidwerkzeug oder einen Teil eines Schneidwerkzeugs, wie bspw. eine Schneidplatte, zur spanabhebenden Bearbeitung.

Zerspanungswerkzeuge unterliegen während des Betriebs einer hohen Verschleißbeanspruchung und sie sind großen Kräften ausgesetzt. Insbesondere die Schneidkante und der Schneidkante benachbarte Flächenbereiche sind sowohl bei der Metallbearbeitung als auch bei der Kunststoffbearbeitung oder der Bearbeitung anderweitiger Werkstoffe stark beansprucht. Von dem Werkstück abgehobene Späne werden bspw. an der Spanfläche umgeleitet, wobei sie unter hohem Druck an Spanflächenbereichen entlang gleiten.

Sowohl Defekte der Schneidkanten eines Schneidwerkzeugs, als auch Flächendefekte kennzeichnen den Verschleißzustand des Werkzeugs. Dieses soll einerseits eine möglichst hohe Standzeit aufweisen, andererseits jedoch auch möglichst eine hohe Zerspanungsleistung erbringen. Der Verschleiß des Werkzeugs steigt jedoch mit der Zerspanungsleistung an.

Es sind Schneidwerkzeuge bekannt, die mit einer verschleißmindernden Beschichtung versehen sind. Die Beschichtungen sind im CVD-Verfahren (chemical vapor deposition) oder im PVD-Verfahren (physical vapor deposition) hergestellt. Z.B. offenbart die EP 0736615 A2 eine mehrschichtige Beschichtung mit insgesamt vier auf einem Substrat aufgebrachten Schichten. Die unmittelbar auf dem Substrat haftende Schicht ist eine TiCₓN_{y}O_{z}-Schicht. Die darauffolgende Schicht ist vorzugsweise eine Titancarbonitrid-Schicht TiₓC_{y}N_{z}. Diese Schicht wird im CVD-Verfahren bei einer Temperatur zwischen 1000 °C und 1100 °C abgeschieden.

Zur Herstellung im PVD-Verfahren werden keine Hinweise gegeben.

Aus der WO-A-96/25291 ist ein PVD-Verfahren zur Herstellung von kristallinen Carbonitridschichten bekannt. Das PVD-Verfahren beruht darauf, dass geeignete kohlenstoffhaltige Targets z.B. aus Graphit, d.h. Kohlenstoff in fester Form, Anwendung finden. Durch die Prozessführung und geeignete Metallkeime wird ein kristalliner Aufbau des Carbonitrids erreicht.

Des Weiteren offenbart die US-A-5840435 ein Herstellverfahren zur Herstellung von C₂N als Schicht beispielsweise auf Titannitrid. Dazu wird wiederum Kohlenstoff von einem Target mittels eines Laserstrahls verdampft, um in einer Stickstoffatmosphäre zu C₂N zu reagieren, das sich auf einem geeigneten Substrat niederschlägt.

Davon ausgehend ist es Aufgabe der Erfindung, ein verschleißfestes Zerspanungswerkzeug sowie ein rationelles Verfahren zu seiner Herstellung zu schaffen.

Diese Aufgabe wird durch das Schneidwerkzeug oder die Schneidplatte mit den Merkmalen des Patentanspruchs 1 gelöst. Außerdem wird ein solches Schneidwerkzeug mit einem Verfahren nach Anspruch 14 erhalten.

Das erfindungsgemäße Schneidwerkzeug oder die für ein Schneidwerkzeug geeignete Schneidplatte weist eine Carbonitrid-Schicht auf. Diese Schicht ist oberflächennah oder an der Oberfläche von beanspruchten Flächenbereichen und ggfs. auch an sonstigen Flächenbereichen ausgebildet. Die Carbonitrid-Schicht enthält Kohlenstoff und Stickstoff, bspw. als Verbindung C₂N oder mit noch höherem Kohlenstoffanteil. Die Bindung zwischen Kohlenstoff und Stickstoff ist vorwiegend eine kovalente Bindung. Ein geringer Metallanteil der Schicht kann eine weitere Bindungsart implizieren. Eine solche Carbonitrid-Schicht zeigt in der Regel einen relativ geringen Reibbeiwert, der geringer ist als die Reibbeiwerte vieler anderer bekannter Hartstoffschichten und Grundmaterialien. Der geringere Reibbeiwert bewirkt einen verschleißarmen Spänefluss. Die Zerspanungsleistung einer Carbonitrid beschichteten Schneidplatte oder eines Carbonitrid beschichteten Schneidwerkzeugs kann gegenüber unbeschichteten oder anderweitig beschichteten Werkzeugen bzw. Schneidplatten gesteigert werden. Der geringere Reibbeiwert vermindert die Schweißneigung von über die betreffende Fläche laufenden Spänen, z.B. bei der Bearbeitung von hoch legierten Stählen, von austenitischen Stählen, von Titan und von Leichtmetall.

Mit Carbonitrid beschichtete Werkzeuge sind insbesondere für die Bearbeitung von aus Titan oder Titanlegierungen bestehenden Teilen geeignet. Im Vergleich zu titanhaltigen Beschichtungen kann hier die Gefahr ausgeschlossen oder reduziert werden, dass die Oberfläche von Titanteilen mit anderweitigen Titanverbindungen kontaminiert wird, was ansonsten häufig Anlass zu Bedenken hinsichtlich der Teilefestigkeit gibt.

Die Carbonitrid-Schicht kann eine Härte aufweisen, die von der Härte des Grundmaterials oder darunter liegender Schichten abweicht, wobei die Härte der Carbonitrid-Schicht nicht nur größer, sondern auch geringer als die Härte darunter liegender Schichten oder des Grundmaterials sein kann.

Die Carbonitrid-Schicht ist vorzugsweise eine MeₓC_{y}N_{z}:H-Schicht oder eine MeₓC_{y}N_{z}Oₛ:H-Schicht (x ≤ 0, 2; y/z ≥ 2/1), wobei das Metall Me durch ein oder mehrere Metalle der vierten Gruppe des Periodensystems der chemischen Elemente oder Aluminium gebildet sein kann. Derartige Metalle sind vorzugsweise in lediglich einem geringem Atomprozentanteil enthalten, so dass die Carbonitrid-Schicht im Wesentlichen aus Kohlenstoff und Stickstoff gebildet ist. Der geringe Metallanteil kann auch entfallen. Bedarfsweise kann er zur gezielten Steuerung der Oberflächeneigenschaften herangezogen werden. Zum Beispiel kann durch einen Titananteil eine Struktur erhalten werden, bei der TiC, TiN oder TiCN-Kristallite in eine CN-Matrix mit hauptsächlich graphitischen Bindungsanteil (kovalente Bindung) eingebettet ist.

Die Carbonitrid-Schicht hat sich insbesondere dann als verschleißmindernd herausgestellt, wenn sie maximal 50 at% Stickstoff und mehr als 50 at% Kohlenstoff enthält. Sie kann dabei bspw. als Polymerstruktur aufwachsen. Bei einer besonders bevorzugten Ausführungsform ist das obige Verhältnis y/z > 2, wobei der Stickstoffgehalt jedoch größer als 10 at% ist. In Ausnahmefällen kann der Stickstoffgehalt bis auf 5 at% reduziert werden.

Die Carbonitrid-Schicht ist vorzugsweise eine Oberflächenschicht, die mit abgetragenen Spänen und sonstigen Werkstückteilen oder Bereichen in Eingriff kommt. Sie kann eine Deckschicht bilden und ist so unmittelbar als Verschleißschutzschicht wirksam. Bedarfsweise kann jedoch noch eine Überzugsschicht vorgesehen sein; bspw. aus dekorativen Gründen.

Die Carbonitrid-Schicht kann unmittelbar auf einen Schneidstoffgrundkörper aufgebracht sein. Dieser kann aus einem Metall, einer Metalllegierung oder einem Keramikwerkstoff sowie einem zwischen den Metallen und der Keramik stehenden Werkstoff (Cermet) bestehen, wie bspw. Wolframcarbid mit geringem Kobaltanteil. In diesem Fall wird die Härte des Grundkörpers mit der verschleißmindernden Eigenschaft der Carbonitrid-Beschichtung kombiniert.

Zwischen dem Grundköper und der Carbonitrid-Schicht können optional ein oder mehrere Zwischenschichten angeordnet sein, um die Oberflächeneigenschaften gezielt zu beeinflussen. Es können dabei relativ harte Zwischenschichten wie bspw. TiAlN, TiCN, TiN, Al₂O₃ oder anderes vorgesehen werden. Besonders vorteilhafte Eigenschaften ergeben sich bei mehrlagigem Aufbau, wenn mindestens eine Lage aus Meₓ(C, N, O) vorgesehen wird. Das Metall ist wiederum vorzugsweise ein Metall der vierten Gruppe des Periodensystems der chemischen Elemente. Bei solchem mehrlagigem Aufbau wird die Härte dieser Zwischenschicht mit den verschleißmindernden Eigenschaften der Carbonitrid-Schicht kombiniert. Dabei kann es genügen, wenn die Carbonitrid-Schicht eine Dicke von bspw. lediglich 0,1µm aufweist. Vorzugsweise ist die Schichtdicke jedoch etwas grö-ßer, um den Verschleißschutz über lange Zeit aufrecht zu erhalten.

Als Gesamtschichtdicke der auf den Grundkörper aufgebrachten Schichten hat sich bei mehrlagigem Aufbau eine Schichtdicke zwischen 0,2 µm und 10 µm herausgestellt.

Die Carbonitrid-Schicht kann einen Metallanteil mit zur Oberfläche hin abfallender Konzentration enthalten. Durch den somit inhomogenen Aufbau der Cabonitrid-Schicht lassen sich deren Eigenschaften, insbesondere hinsichtlich Abrieb, Verschleißfestigkeit und evtl. Beeinflussung des bearbeiteten Materials, noch optimieren.

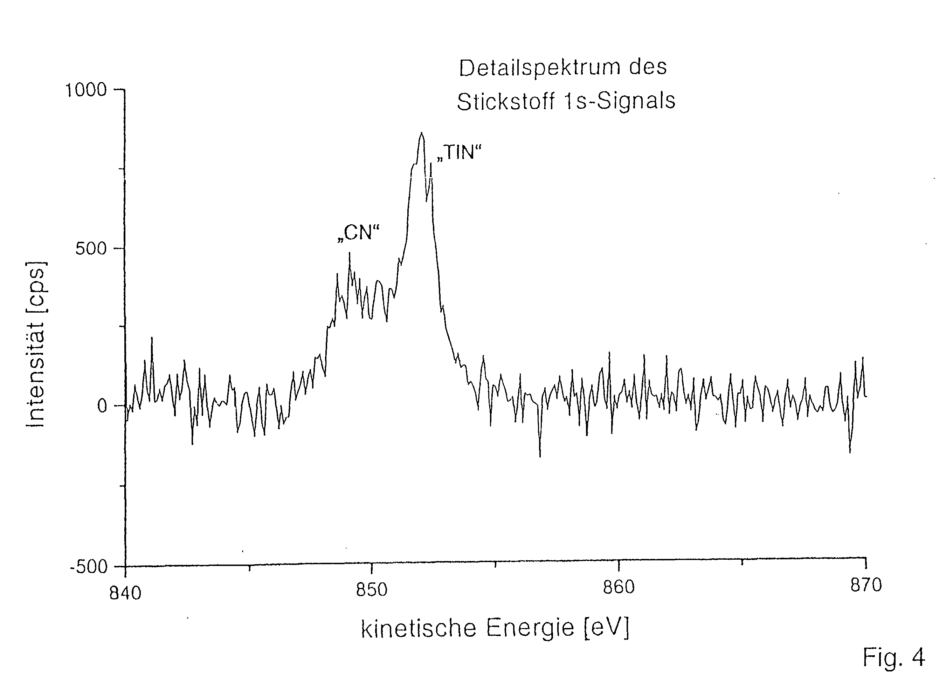

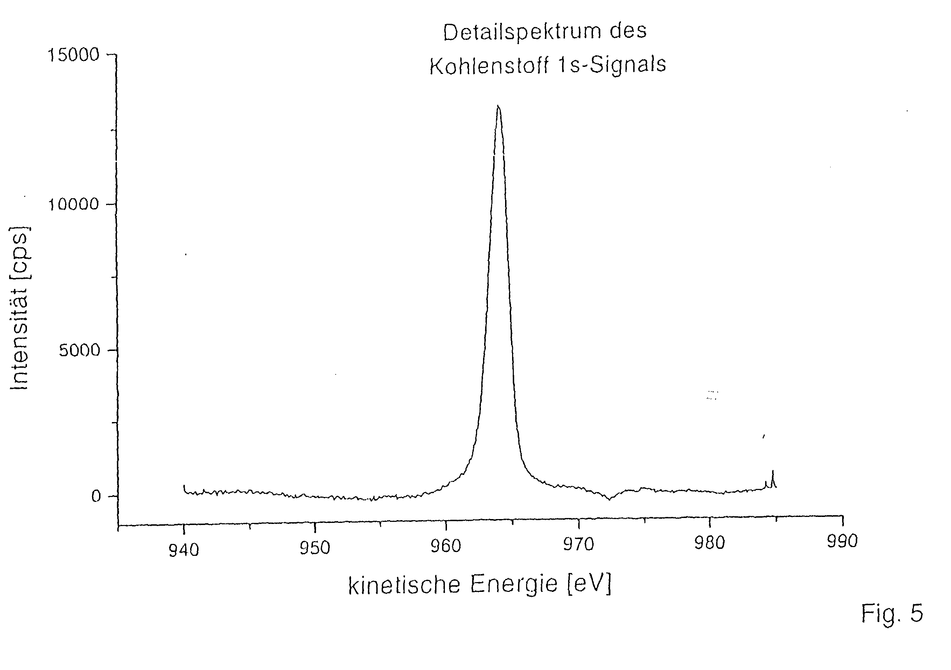

Die Carbonitrid-Schicht, weist ein amorphes Gefüge auf. Die amorphe Struktur kann einzelnen Anwendungsfällen angepasst werden. Hinsichtlich möglicher Bindungszustände wird als Beispiel auf Figur 4 und 5 verwiesen.

Das erfindungsgemäße Verfahren zur Herstellung eines Schneidwerkzeugs führt zu dem gewünschten Schneidwerkzeug. Das Verfahren beinhaltet zunächst die Formgebung des Schneidwerkzeugs oder der Schneidplatte und eine nachfolgende, wenigstens bereichsweise Beschichtung. Dazu wird vorzugsweise eine Abscheidung der CN-Schicht aus einer Niederdruckatmosphäre bevorzugt, die sowohl Kohlenstoff als auch Stickstoff enthält. Das Verfahren ist ein modifiziertes PVD-Verfahren. In einer herkömmlichen PVD-Beschichtungsanlage, die z.B. der Erzeugung von Grundschichten oder anderweitiger Schichten dient, wird die C_{>2}N-Schicht erzeugt, indem Prozessgase in die Beschichtungskammer eingeführt werden. Die Prozessgase sind CH₄ als Kohlenstoffträger und Stickstoff. Der Druck liegt zwischen 10-4 und 10-3 mbar. Durch eine Ionisierung dieser Atmosphäre in Folge eines die Schneidwerkzeuge vorzugsweise ringförmig umgebenden Magnetfelds (ungefähr 1 mT) und einer elektrostatischen Vorspannung der zu beschichtenden Flächen wird eine Dissoziation und Ionisation der Gase und eine gleichmäßige Beschichtung der gewünschten Flächen erreicht. Das Beschichtungsverfahren ist somit ein PVD-CVD-Hybridverfahren. Ein wesentlicher Vorteil des Verfahrens liegt darin CₓN_{y}-Schichten in die Herstellung von anderweitigen Beschichtungen von Schneidwerkzeugen im PVD-Verfahren integrieren zu können, ohne bauliche Veränderungen an der Bedampfungskammer vornehmen zu müssen. Die Carbonitrid-Beschichtung wird durch Einleitung von Prozessgasen mit niedrigem Druck und niedrigen Flüssen in die Bedampfungskammer erzeugt. Es sind weder zusätzliche Targets erforderlich noch werden sonstige vor- oder nachgeordnete Prozesse (Beschichtungsprozesse) behindert.

Das Magnetfeld ist vorzugsweise ein Gleichfeld, das Ionen und Elektronen auf spiralförmige Bahnen zwingt. Als Kohlenstoffspender dient die Atmosphäre der Vakuumkammer ein Graphittarget ist nicht vorhanden. Die Kathodenspannung und das Magnetfeld sind so gewählt, dass ein gezielt geringer Abtrag von den Kathoden erhalten wird. Der abzuscheidende Kohlenstoff wird durch Ionisation/Dissoziation im sich ausbildenden Plasma erhalten. Alle vorhandenen Ionenquellen können in der Vakuumkammer verbleiben. Es ist kein zusätzlicher Platz für eine zusätzliche Komponente (Kohlenstoffquelle) bereitzustellen oder freizumachen.

Als Ionenquelle kann eine Metall- oder Edelgasionenquelle verwendet werden. Eine Metallionenquelle gestattet mit der Abscheidung der Carbonitrid-Schicht auch die Abscheidung eines geringen Metallanteils.

Das Verfahren wird in ein- und demselben Reaktionsraum durchgeführt, wie die zuvor durchlaufenen Beschichtungsprozesse. Wird dazu bspw. eine PVD-Beschichtungsanlage mit vier Ionen- oder Plasmaquellenplätzen verwendet, kann die Carbonitrid-Deckschicht mit der gleichen Anlage ohne zusätzliche Ionenquelle durchgeführt werden, indem im letzten Verfahrensschritt eine kohlenstoff- und stickstoffhaltige Niederdruckatmosphäre aufgebaut wird, wobei bspw. eine Ionenquelle mit Titantarget zur Plasmaerzeugung weiterbetrieben wird.

Weitere Einzelheiten vorteilhafter Ausführungsformen der Erfindung ergeben sich aus der Zeichnung, der Beschreibung oder Unteransprüche. In der Zeichnung sind Ausführungsformen der Erfindung veranschaulicht. Es zeigen:
Fig. 1 ein Schneidwerkzeug mit beschichteten Schneidplatten, in perspektivischer vereinfachter Darstellung,
Fig. 2 eine Einrichtung zur Herstellung beschichteter Schneidwerkzeuge, in schematisierter Darstellung, und
Fig. 3 einen Ausschnitt aus einem Schnitt durch ein Schneidwerkzeug mit beschichteter Oberfläche.
Fig. 4 ein XPS-Detailspektrum einer mit der erfindungsgemäßen Schicht beschichteten Probe (Schneidplatte), für Stickstoff, und
Fig. 5 ein XPS-Detailspektrum einer mit der erfindungsgemäßen Schicht beschichteten Probe (Schneidplatte), für Kohlenstoff.

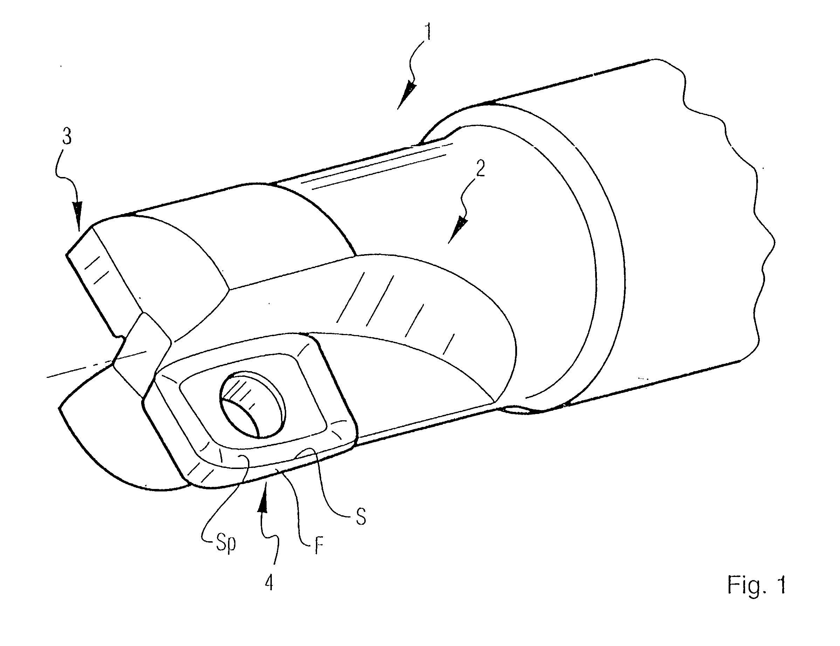

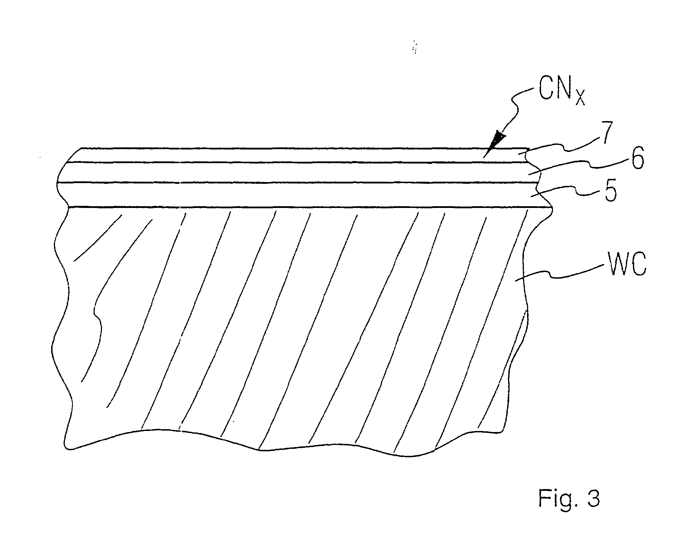

In Figur 1 ist ein Schneidwerkzeug 1 veranschaulicht, das einen Werkzeugkörper 2 und an diesem gehaltene Schneidplatten 3, 4 aufweist. Die Schneidplatten 3, 4 sind untereinander gleich ausgebildet und weisen jeweils einen Grundkörper aus einem Hartmetall (Cermet) wie bspw. Wolframcarbid auf. Die Schneidplatten 3, 4 sind mit einer Beschichtung versehen, wie sie aus Figur 3 hervorgeht. Dem Grundkörper aus Wolframcarbid WC sind mehrere Schichten 5, 6, 7 aufgelagert. Die Schicht 7 bildet dabei die äußere Deckschicht. Sie ist eine Carbonitrid-Schicht CₓN_{y} mit einer Dicke von etwa 0,1 µm. Die Deckschicht 7 kann außer Kohlenstoff und Stickstoff noch Metall und Wasserstoff enthalten. Die Schicht 7 (MeₓCN:H) ist eine Verschleißschutzschicht, die gegenüber gängigen Werkstoffen wie bspw. Aluminium, sonstigem Leichtmetall, Titan oder auch Kunststoff sowie verschiedenen Stählen, insbesondere austenitischen oder hochlegierten Stählen einen geringen Reibbeiwert aufweist. Zur Beeinflussung der Schichteigenschaften kann der Metallanteil Meₓ variiert werden. Es wird angestrebt, dass der Metallgehalt 10 at% nicht überschreitet. Vorzugsweise liegt er unter 5 at%. Als Metalle kommen Titan, Zirconium, Aluminium und ähnliches in Frage. Der in Atomprozent gemessene Kohlenstoffgehalt ist vorzugsweise größer als der in Atomprozent gemessene Stickstoffgehalt.

Wenigstens eine der darunter liegenden Schichten 5, 6 kann zusätzlich Sauerstoff enthalten und bildet eine Lage aus Meₓ (C, N, 0), wobei Meₓ für ein oder mehrere Metalle aus Gruppe IV steht.

Ein solches Zerspanungswerkzeug hat sich als äußerst verschleißfest erwiesen. Insbesondere die Schweißneigung und der Oberflächenverschleiß der Spanfläche in unmittelbarer Nachbarschaft zur Schneidkante ist gering. Beschichtete Flächenbereiche sind in Figur 1, insbesondere die an die Schneidkante S anschließende Spanfläche Sp und die Freifläche F. Im einfachsten Fall ist die Schneidplatte 3, 4 vollständig beschichtet.

Zur Erzeugung der Beschichtung kann folgendermaßen vorgegangen werden:

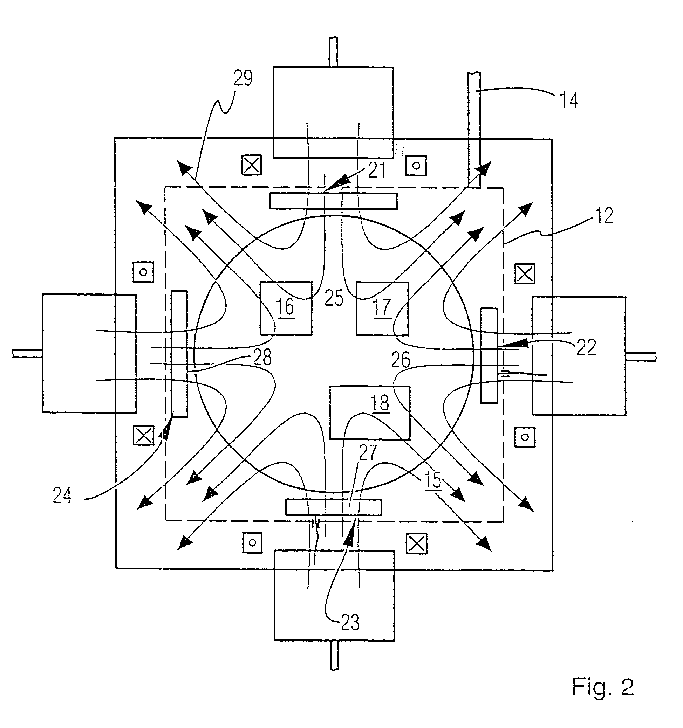

Die Beschichtung wird nach einem modifizierten PVD-Verfahren in einer in Figur 2 schematisch veranschaulichten Anordnung 11 durchgeführt. Diese weist einen Reaktionsraum 12 auf, der nach außen hin hermetisch abschließbar ist. In dem Reaktionsraum 12 ist ein Vakuum erzeugbar, wobei über eine in Figur 2 schematisch veranschaulichte Zuleitung 14 gezielt Gase in den Innenraum 15 einführbar sind. In diesem sind außerdem ein- oder mehrere Halter 16, 17, 18 für Schneidwerkzeuge, Schneidplatten oder Schneidwerkzeug- oder Schneidplattenträger angeordnet. Außerdem sind in dem evakuierbaren Innenraum 15 vier Ionenquellen 21, 22, 23, 24 angeordnet, die jeweils ein Target, bspw. ein Metalltarget 25, 26, 27, 28 (z.B. jeweils in Form einer Platte) aufweisen. Die Targets 21 bis 24 sind die erforderlichen Targets zur Herstellung der unter der Deckschicht 7 liegenden Schichten 5, 6. Weitere Plätze zur Anordnung solcher Ionenquellen sind nicht vorhanden. Die Targets 21-24 bilden Kathoden. In dem Innenraum wird ein Plasma erzeugt, aus dem Ionen auf die Targets treffen und Metallatome zur Abscheidung auf den Schneidplatten herauslösen. Zur Steuerung der Abscheidung sind die Halter 16, 17, 18 mit einer Vorspannung beaufschlagbar. Außerdem kann ein die zu beschichtenden Teile ringförmig umgebendes Magnetfeld 29 aufgebaut werden. Dieser wird vorzugsweise durch Spulen mit radial orientierter Spulenachse und gleichsinniger Erregung erzeugt.

Zum Aufbau der gewünschten Schichten werden zunächst die Schneidwerkzeuge oder Schneidplatten in den Innenraum 15 gebracht und auf den Haltern 16, 17, 18 abgelegt. Nachfolgend wird der Innenraum 15 evakuiert und mit bspw. einem Edelgas mit sehr geringem Druck gefüllt. Durch entsprechende Ansteuerung der Ionenquellen können nun die Schichten 5 und 6 im an sich bekannten PVD-Beschichtungsverfahren hergestellt werden. Bedarfsweise können die Schichten 5, 6 auch im CVD-Verfahren oder anderweitig aufgebracht werden. Sind diese Schichten 5, 6 aufgebracht, wird ein modifizierter PVD-Beschichtungsprozess durchgeführt, in dem über die Leitung 14 nun kohlenstoff- und stickstoffhaltiges Gas in den Innenraum 15 eingelassen wird. Dies allerdings bei geringem Druck von maximal wenigen Millibar (10⁻² ... 10⁻⁴ mbar). Ein oder mehrere Ionenquellen können weiterbetrieben werden, um eine Ionisation des Gases und eine Plasmabildung zu bewirken. Aus dem sich bildenden Plasma scheiden sich bei entsprechender Vorspannung und bei entsprechendem Magnetfeld auf den Schneidwerkzeugen oder Schneidplatten die gewünschten CₓN_{y}-Schichten ab. Ein chemisches Gleichgewicht entsteht nicht. Die Beschichtungseinrichtung kann auch mit lediglich einer der beschriebenen Ionenquellen auskommen. Anstelle der anderen Ionenquellen könne andere zur Abscheidung geeignete Komponenten vorgesehen sein.

Die Beschichtung erfolgt in der Vakuumkammer bei einer Temperatur von 200°C bis 300°C und Gaszuflüssen zwischen 50 und 100 sccm [Standard Zentimeter pro Minute] Methan sowie zwischen 10 und 100 sccm Stickstoff. Die elektrische Vorspannung kann von -30 bis -200V betragen, wobei ein Kammerinnendruck von Druck von 10⁻³ mbar bis 10⁻² bar eingehalten wird. in Extremfällen kann der Druck höher liegen.

Mit dem derart modifizierten PVD-Beschichtungsverfahren lassen sich mit herkömmlichen Beschichtungsanlagen ohne große apparatetechnische Modifikationen CN-Deckschichten erzeugen, die eine wesentliche Verschleißreduktion an den Schneidwerkzeugen und somit eine Erhöhung der Zerspanungsleistung erbringen können.

Figur 4 veranschaulicht ein XPS-Detailspektrum, wie erhalten worden ist, indem die Schneidplatte 4, d.h. insbesondere deren Deckschicht 7, einer Mg k α-Röntgenstrahlung ausgesetzt worden ist (Magnesium-Bremselektrode, K-Schale, α-Übergang).

Die durch Anregung der ls-Schale des enthaltenen Stickstoffs erhalten Sekundärelektronen weisen eine kinetische Energie zwischen 848V und 850 eV auf. Der erhaltene N 1s-Peak des Stickstoffs ist einer CN-Bindung zuzuordnen und liegt etwa 3eV von dem benachbarten 1s Peak entfernt, der TiN-Bindungen zuzuordnen ist.

Figur 5 zeigt ein XPS-Detailspektrum der Probe mit Mg k α-Röntgenstrahlung. Die zur Entfernung aller Oberflächenkontaminationen ionengeätzte Schicht 7 zeigt einen ausgeprägten C 1s-Peak. Der Kohlenstoff liegt somit als graphitische Matrix vor. Aufgrund der großen Signalstärke des C 1s-Signals für C-C-Bindungen ist in Figur 5 kein deutliches Signal für Kohlenstoff in CN-Bindungen zu sehen.

Ein Schneidwerkzeug ist wenigstens bereichsweise mit einer Carbonitrid-Beschichtung versehen, die reibungsmindernd und als Verschleißschutzschicht wirkt. Die Beschichtung wird in einem modifizierten PVD-Verfahren aufgebracht, in dem zur Erzeugung der Carbonitrid-Schicht Kohlenstoff und Stickstoff als Gas in den Reaktionsraum eingebracht und ein- oder mehrere Ionenquellen zur Plasmabildung weiterbetrieben werden.

## Patentansprüche

1. Schneidwerkzeug (1) oder Schneidplatte (3, 4) mit einer verschleißmindernden Beschichtung in Form einer amorphen Schicht, die Carbonitrid (CₓN_{y}) in kovalenter Bindung enthält wobei CₓN_{y} mit x/y ≥ 2 vorhanden ist und
wobei der Carbonitridanteil der Beschichtung eine solche C-N Bindung aufweist, dass er bei einer Bestrahlung mit Mg K α-Röntgenstrahlung Sekundärelektronen mit einer kinetischen Energie zwischen 848 und 850 eV liefert.

2. Schneidwerkzeug oder -platte nach Anspruch 1, **dadurch gekennzeichnet, dass** die Carbonitrid-Schicht eine MeₓC_{y}N_{z}Oₛ:H-Schicht (x ≤ 0,2; y/z ≥ 2/1) ist, wobei das Metall Me ein oder mehrere Metalle der Gruppe IV des Periodensystems der chemischen Elemente (Titan, Zirkonium, Aluminium o.ä.) ist, wobei der Sauerstoffanteil kleiner als 20 at% ist und wobei die Schicht unterschiedliche Phasen enthält (mehrphasiges Gefüge).

3. Schneidwerkzeug oder -platte nach Anspruch 1 oder 2, **dadurch gekennzeichnet, dass** die Carbonitrid-Schicht maximal 30 at% Stickstoff (N), dass der Metallanteil (Me) maximal 10 at% beträgt.

4. Schneidwerkzeug oder -platte nach Anspruch 3, **dadurch gekennzeichnet, dass** der Metallanteil höchstens 5 at% beträgt.

5. Schneidwerkzeug oder -platte nach Anspruch 1 oder 2, **dadurch gekennzeichnet, dass** die Carbonitrid-Schicht eine Oberflächenschicht ist.

6. Schneidwerkzeug oder -platte nach Anspruch 1, **dadurch gekennzeichnet, dass** die Carbonitrid-Schicht auf einem Schneidstoff-Grundkörper aufgebracht ist, der aus einem Metall, einer Metall-Legierung, Hartmetall oder einem Keramikwerkstoff besteht.

7. Schneidwerkzeug oder -platte nach Anspruch 6, **dadurch gekennzeichnet, dass** zwischen dem Schneidstoff-Grundköper und der Carbonitrid-Schicht eine ein- oder mehrlagige Zwischenschicht angeordnet ist, die ein oder mehrere Stoffe enthalten kann, die aus der folgenden Gruppe ausgewählt sind: TiAlN, TiCN, TiN, ZrN, Al₂O₃, wobei die ein- oder mehrlagige Zwischenschicht optional weitere Stoffe oder Schichten enthalten kann.

8. Schneidwerkzeug oder -platte nach Anspruch 1, **dadurch gekennzeichnet, dass** zwischen dem Schneidstoff-Grundkörper und der Carbonitrid-Schicht wenigstens eine Schicht Meₓ(C,N,O) angeordnet ist (z.B. TiCN, TiALCN, TiAIN o.ä.).

9. Schneidwerkzeug oder -platte nach Anspruch 1, **dadurch gekennzeichnet, dass** die Carbonitrid-Schicht eine Dicke von wenigstens 0,1 µm aufweist.

10. Schneidwerkzeug oder -platte nach Anspruch 1 oder 7, **dadurch gekennzeichnet, dass** die Gesamtschichtdicke der Carbonitrid-Schicht und, falls vorhanden, einer unter dieser liegenden Schicht 0,2 µm bis 10 µm beträgt.

11. Schneidwerkzeug oder -platte nach Anspruch 1, **dadurch gekennzeichnet, dass** die Carbonitrid-Schicht einen zur Oberfläche hin abfallenden Metallanteil aufweist.

12. Schneidwerkzeug oder -platte nach Anspruch 11, **dadurch gekennzeichnet, dass** die Carbonitrid-Schicht an der von der Oberfläche abgewandten Seite einen Metallanteil von maximal 50 at% aufweist, der zu der Oberfläche hin abnimmt.

13. Schneidwerkzeug oder -platte nach Anspruch 1, **dadurch gekennzeichnet, dass** auf der Carbonitrid-Schicht eine Deckschicht aufgebracht ist.

14. Verfahren zum Herstellen eines Schneidwerkzeugs oder einer Schneidplatte nach Anspruch 1, bei dem
ein Grundkörper in einem ersten Schritt zumindest in seinen zu beschichtenden Bereichen eine gewünschte Form einschließlich der funktionell bedeutsamen Kanten und Flächen erhält, wonach
der Grundkörper in einer Vakuumkammer einer wenigstens teilweise ionisierten, sowohl Kohlenstoff als auch Stickstoff enthaltenden Atmosphäre ausgesetzt wird,
wobei die Carbonitrid-Deckschicht in der gleichen Vakuumkammer erzeugt wird, wie vorherige Schichten und
das oder die vorausgegangenen Beschichtungsverfahren PVD-Beschichtungsverfahren sind, bei denen in einem Vakuumkammer unter geringem Druck Material von einem Target abgetragen und auf der zu beschichtenden Fläche abgeschieden wird,
**dadurch gekennzeichnet, dass** zur Erzeugung der Carbonitrid-Deckschicht danach kohlenstoffhaltiges und Stickstoffhaltiges Gas unter geringem Druck in die gleiche Vakuumkammer eingebracht und mittels vorhandener Ionenquellen ionisiert wird und
dass die Beschichtung in der Vakuumkammer bei einer Temperatur von 200°C bis 300°C und Gaszuflüssen zwischen 50 und 100 sccm Methan, als kohlenstoffhaltiges Gas, sowie zwischen 10 und 100 sccm Stickstoff bei einer elektrischen Vorspannung von -30 bis -200V und einem Druck von 10⁻³ mbar bis 1 bar erzeugt wird.

15. Verfahren nach Anspruch 14, **dadurch gekennzeichnet, dass** die Ionisierung durch eine Ionen-Plasmaquelle in Verbindung mit einem Magnetfeld erzeugt wird.

16. Verfahren nach Anspruch 15, **dadurch gekennzeichnet, dass** das Magnetfeld ein Gleichfeld ist, das das zu beschichtende Schneidwerkzeug oder die Schneidplatte umgibt.

17. Verfahren nach Anspruch 14, **dadurch gekennzeichnet, dass** als Ionenquelle eine Metall- oder Edelgasionenquelle verwendet wird.

## Claims

1. Cutting tool (1) or cutting tip (3, 4) with a wear-reducing coating in the form of an amorphous layer, which contains carbonitride (CₓN_{y}) in a covalent bond, wherein CₓN_{y} is present with x/y ≥ 2 and
wherein the carbonitride content of the coating has such a C-N bond that on exposure to Mg K α x-ray radiation it contributes secondary electrons with a kinetic energy of between 848 and 850 eV.

2. Cutting tool or tip according to Claim 1, **characterised in that** the carbonitride layer is an MeₓC_{y}N_{z}Oₛ: H layer (x ≤ 0.2; y/z ≥ 2/1), wherein the metal Me is one or more metals of group IV of the periodic system of chemical elements (titanium, zirconium, aluminium or similar), wherein the oxygen content is less than 20 atom % and wherein the layer contains different phases (multiphase structure).

3. Cutting tool or tip according to Claim 1 or 2, **characterised in that** the carbonitride layer [contains?] a maximum of 30 atom % nitrogen (N), that the metal content (Me) amounts to a maximum of 10 atom %.

4. Cutting tool or tip according to Claim 3, **characterised in that** the metal content amounts to 5 atom % at most.

5. Cutting tool or tip according to Claim 1 or 2, **characterised in that** the carbonitride layer is a surface layer.

6. Cutting tool or tip according to Claim 1, **characterised in that** the carbonitride layer is applied to a cutting material base body, which is composed of a metal, a metal alloy, hard metal or a ceramic material.

7. Cutting tool or tip according to Claim 6, **characterised in that** arranged between the cutting material base body and the carbonitride layer is a single-or multi-layered intermediate layer, which can contain one or more materials selected from the following group: TiAIN, TiCN, TiN, ZrN, Al₂O₃, wherein the single- or multi-layered intermediate layer can optionally contain further materials or layers.

8. Cutting tool or tip according to Claim 1, **characterised in that** at least one Meₓ(C, N, O) layer (e.g. TiCN, TiAlCN, TiAlN or similar) is arranged between the cutting material base body and the carbonitride layer.

9. Cutting tool or tip according to Claim 1, **characterised in that** the carbonitride layer has a thickness of at least 0.1 µm.

10. Cutting tool or tip according to Claim 1 or 7, **characterised in that** the total layer thickness of the carbonitride layer and, if present, of a layer lying under this amounts to 0.2 µm to 10 µm.

11. Cutting tool or tip according to Claim 1, **characterised in that** the carbonitride layer has a metal content, which decreases towards the surface.

12. Cutting tool or tip according to Claim 11, **characterised in that** on the side remote from the surface the carbonitride layer has a metal content of a maximum of 50 atom %, which decreases towards the surface.

13. Cutting tool or tip according to Claim 1, **characterised in that** a covering layer is applied to the carbonitride layer.

14. Process for the production of a cutting tool or a cutting tip according to Claim 1, wherein
in a first step a base body is provided, at least in its regions to be coated, with a desired shape including the functionally important edges and faces, after which
in a vacuum chamber the base body is exposed to an at least partially ionising atmosphere containing both carbon and nitrogen,
wherein the carbonitride covering layer is generated in the same vacuum chamber as previous layers, and
the preceding coating process or processes is/are PVD coating processes, in which at low pressure in a vacuum chamber material is removed from a target and deposited on the face to be coated,
**characterised in that** to generate the carbonitride covering layer gas containing carbon and nitrogen is then fed at low pressure into the same vacuum chamber and is ionised by means of ion sources present, and
that the coating is generated in the vacuum chamber at a temperature of 200°C to 300°C and with gas flows of between 50 and 100 sccm of methane, as carbon-containing gas, and of between 10 and 100 sccm of nitrogen at an electrical bias of-30 to -200 V and a pressure of 10⁻³ mbar to 1 bar.

15. Process according to Claim 14, **characterised in that** the ionisation is generated by an ion plasma source in association with a magnetic field.

16. Process according to Claim 15, **characterised in that** the magnetic field is a continuous field, which surrounds the cutting tool or cutting tip to be coated.

17. Process according to Claim 14, **characterised in that** a metal or noble gas ion source is used as ion source.

## Revendications

1. . Outil de coupe (1) ou plaquette de coupe (3, 4) pourvu d'un revêtement réduidant l'usure, qui se présente sous la forme d'une couche amorphe contenant du carbonitrure (CₓN_{y}) en liaison covalente, dans lequel CₓN_{y} est présent avec x/y ≥ 2 et
la part de carbonitrure dans le revêtement présente une liaison C-N telle que sous une irradiation par un rayonnement K-α Mg, celui-ci émet des électrons secondaires dotés d'une énergie cinétique comprise entre 848 et 850 eV.

2. . Outil de coupe ou plaquette de coupe selon la revendication 1, **caractérisé par le fait que** le revêtement de carbonitrure est une couche MeₓC_{y}N_{z}Oₛ:H, (x ≤ 02; y/z ≥ 2/1), le métal Me étant un métal ou plusieurs métaux appartenant au Groupe IV de la Classification Périodique des Eléments Chimiques (titane, zirconium, aluminium, ou similaire), la fraction d'oxygène étant inférieure à 20 % en atomes et la couche contenant différentes phases (structure multiphase).

3. . Outil de coupe ou plaquette de coupe selon la revendication 1 ou 2, **caractérisé par le fait que** le revêtement de carbonitrure contient au maximum 30% en atomes d'azote (N) et que la fraction de métal (Me) est au maximum de 10% en atomes.

4. . Outil de coupe ou plaquette de coupe selon la revendication 3, **caractérisé par le fait que** la fraction de métal est de 5% en atomes maximum.

5. . Outil de coupe ou plaquette de coupe selon la revendication 1 ou 2, **caractérisé par le fait que** le revêtement de carbonitrure est une couche superficielle.

6. . Outil de coupe ou plaquette de coupe selon la revendication 1, **caractérisé par le fait que** le revêtement de carbonitrure est appliqué sur un corps de base d'outil de coupe constitué d'un métal, d'un alliage métallique, d'un métal dur ou d'un matériau céramique.

7. . Outil de coupe ou plaquette de coupe selon la revendication 6, **caractérisé par le fait qu'**entre le corps de base d'outil de coupe et le revêtement de carbonitrure est disposée une couche intermédiaire monocouche ou multicouche, qui peut contenir une ou plusieurs matières choisies parmi le groupe de matières suivant: TiAIN, TiCN, TiN, ZrN, Al₂O₃, là couche intermédiaire monocouche ou multicouche pouvant éventuellement contenir d'autres matières ou d'autres couches.

8. . Outil de coupe ou plaquette de coupe selon la revendication 1, **caractérisé par le fait qu'**entre le corps de base d'outil de coupe et le revêtement de carbonitrure est disposée au moins une couche Meₓ(C, N, O) (par exemple TiCN, TiAlCN, TiAlN, ou similaire).

9. . Outil de coupe ou plaquette de coupe selon la revendication 1, **caractérisé par le fait que** le revêtement de carbonitrure a une épaisseur d'au moins 0,1 µm.

10. . Outil de coupe ou plaquette de coupe selon la revendication 1 ou 7, **caractérisé par le fait qu'**entre l'épaisseur de couche totale du revêtement de carbonitrure et, lorsqu'elle est présente, d'une couche placée sous celui est comprise entre 0,2 µm et 10 µm.

11. . Outil de coupe ou plaquette de coupe selon la revendication 1, **caractérisé par le fait que** le revêtement de carbonitrure présente une proportion de métal qui décroît en direction de la surface.

12. . Outil de coupe ou plaquette de coupe selon la revendication 1, **caractérisé par le fait que** le revêtement de carbonitrure présente une fraction de métal dont le gradient décroît en direction de la surface.

13. . Outil de coupe ou plaquette de coupe selon la revendication 1, **caractérisé par le fait qu'**une couche de couverture est appliquée sur le revêtement de carbonitrure.

14. . Procédé de fabrication d'un outil de coupe ou d'une plaquette de coupe selon la revendication 1, dans lequel
au cours d'une première étape, un corps de base reçoit, au moins dans ses parties à revêtir, une forme souhaitée ainsi que les arêtes et surfaces importantes au plan fonctionnel, puis
le corps de base placé dans une chambre à vide est exposé à une atmosphère au moins partiellement ionisée contenant à la fois du carbone et de l'azote,
la couche de couverture de carbonitrure étant produite dans la même chambre à vide que les couches précédentes et
le ou les procédés de revêtement précédent(s) étant des procédés de revêtement PVD dans lesquels, dans une chambre à vide, sous faible pression, de la matière est prélevée sur une cible et déposée sur la surface à revêtir,
**caractérisé par le fait que** pour produire la couche de couverture de carbonitrure on introduit ensuite dans la même chambre à vide, sous une faible pression, un gaz contenant du carbone et de l'azote et on l'ionise avec les sources d'ions disponibles,
et qu'on produit le revêtement dans la chambre à vide, sous une température de 200 °C à 300 °C et avec des apports de gaz compris entre 50 et 100 sccm de méthane, comme gaz contenant du carbone, et entre 10 et 100 sccm d'azote, sous une tension électrique comprise entre -30 et -200 V et une pression comprise entre 10⁻³ mbar et 1 bar.

15. . Procédé selon la revendication 14, **caractérisé par le fait que** l'ionisation est produite à l'aide d'une source plasma en liaison avec un champ magnétique.

16. . Procédé selon la revendication 15, **caractérisé par le fait que** le champ magnétique est un champ constant qui entoure l'outil de coupe ou la plaquette de coupe à revêtir.

17. . Procédé selon la revendication 14, **caractérisé par le fait que** l'on utilise comme source d'ions une source d'ions de métaux ou gaz rares.
